# EUROPÄISCHE PATENTSCHRIFT

(11) **EP 3 100 009 B1**
(45) Veröffentlichungstag und Bekanntmachung des Hinweises auf die Patenterteilung: **24.04.2019**
(21) Anmeldenummer: 15705180.6
(22) Anmeldetag: 15.01.2015
(51) Int. Cl.: G01D 15/00, G11C 7/00, G01D 11/30

(54) **MESSEINRICHTUNG MIT MAGNETISCH GEKOPPELTEN DATENÜBERTRAGUNGS- UND DATENAUSLESETEILEN**
MEASURING DEVICE WITH MAGNETICALLY COUPLED DATA READING AND DATA TRANSMISSION UNITS
DISPOSITIF DE MESURE AVEC DISPOSITIF DE LECTURE DES DONNÉES ET DISPOSITIF DE TRANSMISSION DE DONNÉES COUPLÉS MAGNÉTIQUEMENT

(30) Priorität: 30.01.2014 DE 102014201666
(43) Veröffentlichungstag der Anmeldung: 07.12.2016
(73) Patentinhaber: Prüftechnik Dieter Busch AG, 85737 Ismaning (DE)
(72) Erfinder: LYSEN, Heinrich, 85748 Garching (DE)
(86) Internationale Anmeldenummer: PCT/DE2015/200003
(87) Internationale Veröffentlichungsnummer: WO 2015/113563

(56) Entgegenhaltungen:
- EP-A2- 1 865 581
- DE-A1- 19 930 642
- DE-C1- 19 511 280
- GB-A- 2 481 386
- US-A1- 2009 237 011

## Beschreibung

Die vorliegende Erfindung betrifft eine Messeinrichtung mit einem Übertragungsteil und einem Datenausleseteil sowie ein System mit einer derartigen Messeinrichtung.

Systeme, die eine Messeinrichtung mit einem an einem Messobjekt anbringbaren Übertragungsteil und einem Datenausleseteil umfassen, sind beispielsweise aus der EP 0 211 212 B1 und der WO 99/05486 A1 bekannt, während die WO 91/16636 A1 einen auf einem Träger angeordneten Beschleunigungssensor zeigt. Häufig ist das Übertragungsteil mit einem Datenspeicher versehen. Im Datenspeicher können von verschiedenen Sensoren, beispielsweise Temperatursensoren, erfasste Messgrößen des Messobjektes, wie zum Beispiel dessen Temperatur, zwischengespeichert werden. Ferner ist oftmals eine Kennung im Datenspeicher gespeichert, mittels der sich eine Messstelle am Messobjekt, an der das Übertragungsteil angebracht ist, eindeutig identifizieren lässt. Mit dem Datenausleseteil können alle diese Daten aus dem Datenspeicher zur weiteren Verarbeitung ausgelesen werden. Hierzu wird das Datenausleseteil mit dem Übertragungsteil gekoppelt. Insbesondere dann, wenn die Messeinrichtung der Vibrations- oder Schwingungsmessung dient, ist das Datenausleseteil ferner mit einem entsprechenden Sensor ausgestattet welcher es dem Datenausleseteil ermöglicht, vom Übertragungsteil mechanisch an das Datenausleseteil übertragene Vibrationen oder Schwingungen des Messobjektes direkt und in Echtzeit zu messen anstatt von anderen Sensoren zuvor gemessene und im Datenspeicher abgelegte Daten aus dem Datenspeicher auszulesen. Problematisch ist bei derartigen Vorrichtungen, dass das Datenausleseteil nicht nur mechanisch sicher und fest mit dem Übertragungsteil gekoppelt, sondern zudem auch eine verlässliche Kontaktierung zwischen elektrischen Kontakten des Übertragungsteils und des Datenausleseteils gewährleistet sein muss, damit Daten fehlerfrei aus dem Datenspeicher ausgelesen werden können. All dies bedingt recht komplexe und damit schwer herstellbare Kopplungsmechanismen, die zudem mit hohen Kosten einhergehen. Ferner erweist sich das Koppeln des Datenausleseteils an das Übertragungsteil als zeitraubend und umständlich.

Die Dokumente GB 2481386 A und DE 19511280 C1 zeigen magnetische Kopplungen, über die eine sichere elektrische Verbindung zwischen zwei zu kontaktierenden Teilgeräten hergestellt wird.

Es ist daher die Aufgabe der vorliegenden Erfindung, eine Messeinrichtung mit einem Übertragungsteil und einem Datenausleseteil, ein System mit einer derartigen Messeinrichtung sowie ein hierfür geeignetes Übertragungsteil und ein Datenausleseteil zu schaffen, die einen einfachen und robusten Kopplungsmechanismus zwischen Übertragungsteil und Datenausleseteil aufweisen oder bedingen.

Diese Aufgabe wird durch die Messeinrichtung mit den Merkmalen des Anspruchs 1, durch das System mit den Merkmalen des Anspruchs 9, durch das Übertragungsteil mit den Merkmalen des Anspruchs 10 und durch das Datenausleseteil mit den Merkmalen des Anspruchs 11 gelöst. Bevorzugte Ausführungsbeispiele sind Gegenstand der abhängigen Ansprüche.

Gemäß der vorliegenden Erfindung weisen die ersten elektrischen Kontakte bzw. Kontaksegmente des Übertragungsteils Oberflächen auf, die jeweilige Teilbereiche einer Anlagefläche bzw. Ansetzfläche des Übertragungsteils bilden. Ebenso weisen die zweiten elektrischen Kontakte bzw. Kontaktsegmente des Datenausleseteils Oberflächen auf, die jeweilige Teilbereiche einer Anlagefläche bzw. Ansetzfläche des Datenausleseteils bilden. Im entkoppelten Zustand, in welchem die Anlagefläche des Übertragungsteils von der Anlagefläche des Datenausleseteils beabstandet oder getrennt ist, und in der die ersten elektrischen Kontakte von den zweiten elektrischen Kontakten beabstandet oder getrennt sind, sind insbesondere auch das Datenausleseteil und das Übertragungsteil als solche voneinander beabstandet oder getrennt. Hingegen sind das Datenausleseteil und das Übertragungsteil im gekoppelten Zustand der Messeinrichtung aufgrund der vom Magneten bewirkten Anziehungskraft aneinander gekoppelt, wobei zumindest die Anlagefläche des Übertragungsteils und die Anlagefläche des Datenausleseteils sowie die ersten und zweiten elektrischen Kontakte aneinander anliegen. Hierdurch ist ein einfach und preisgünstig herzustellender Kopplungsmechanismus realisiert, der zudem ein schnelles und bequemes An- und Entkoppeln des Datenausleseteils an das Übertragungsteil und vom Übertragungsteil erlaubt. Zudem ist infolge der magnetischen Anziehungskraft eine mechanisch stabile Kopplung des Datenausleseteils an das Übertragungsteil möglich, während die spezifische Ausführung der Anlageflächen und der elektrischen Kontakte eine störungsfrei elektrisch leitende, nach außen elektrisch isolierende Verbindung zwischen dem Übertragungsteil und dem Datenausleseteil bedingt, wodurch Daten fehlerfrei aus dem Datenspeicher ausgelesen werden können.

Insbesondere bilden die Oberflächen der ersten elektrischen Kontakte disjunkte bzw. voneinander getrennte Teilbereiche der Anlagefläche des Übertragungsteils, die entweder vollständig oder lediglich teilweise durch die Gesamtheit der Oberflächen der ersten Kontakte ausgebildet sein kann, wobei es sich bei der Anlagefläche des Übertragungsteils sowohl um eine unzusammenhängende Fläche als auch um eine zusammenhängende Fläche handeln kann. Entsprechend bilden die Oberflächen der zweiten elektrischen Kontakte disjunkte bzw. voneinander getrennte Teilbereiche der Anlagefläche des Datenausleseteils, die entweder vollständig oder lediglich teilweise durch die Gesamtheit der Oberflächen der zweiten Kontakte ausgebildet sein kann, wobei es sich bei der Anlagefläche des Datenausleseteils sowohl um eine unzusammenhängende Fläche als auch um eine zusammenhängende Fläche handeln kann. Unzusammenhängende Anlageflächen liegen insbesondere bei vorspringenden Kontakten vor, wobei eine Anlagefläche durch die Gesamtheit von denjenigen Oberflächen von Kontakten, die Teilbereiche dieser Anlagefläche bilden, vorzugsweise vollständig ausgebildet sein kann. Dabei liegen im gekoppelten Zustand der Messeinrichtung die Anlagefläche des Übertragungsteils und die Anlagefläche des Datenausleseteils unbeachtlich dessen, ob es sich bei ihnen um unzusammenhängende oder zusammenhängende Flächen handelt, zumindest mit den durch die Oberflächen der elektrischen Kontakte gebildeten Teilbereichen aneinander an. Bevorzugt ist im gekoppelten Zustand der Messeinrichtung die vom Magneten bewirkte Anziehungskraft normal oder im Wesentlichen normal zu den Oberflächen der ersten elektrischen Kontakte und den Oberflächen der zweiten elektrischen Kontakte bzw. der Anlagefläche des Übertragungsteils und der Anlagefläche des Datenausleseteils, sie kann aber auch einen Winkel mit diesen Oberflächen bilden.

Bei dem Messobjekt kann es sich um eine beliebige Vorrichtung, Maschine oder Anlage sowie um feste oder bewegliche Teile derselben handeln, wie zum Beispiel um Wellen, Achsen oder Walzen. Das Übertragungsteil kann fest oder beweglich oder lösbar am Messobjekt anbringbar sein.

Bevorzugt sind das Übertragungsteil oder das Datenausleseteil wenigstens teilweise aus einem Stahl hergestellt, wie zum Beispiel einem Automatenstahl, der zudem mit einer galvanischen Schutzschicht überzogen sein kann. Ganz allgemein können die ersten und zweiten Kontakte aus einem beliebigen Metall hergestellt sein, wie zum Beispiel Kupfer, Nickel, Edelstahl oder Gold. So sind zum Beispiel Goldkontakte aufgrund ihrer elektrischen Eigenschaften und der Korrosionsbeständigkeit vorteilhaft.

Die Messeinrichtung kann ganz allgemein zur Messung beliebiger Messgrößen des Messobjektes vorgesehen sein, wofür sie einen oder mehrere gleich- oder verschiedenartige Sensoren aufweisen kann, die an unterschiedlichen Stellen des Messobjektes, im oder am Übertragungsteil, im oder am Datenausleseteil oder ausschließlich im Datenausleseteil angeordnet sein können. Von außerhalb des Datenausleseteils angeordneten Sensoren erfasste Messwerte können im Datenspeicher des Übertragungsteils zwischengespeichert werden, aus dem sie nach Ankoppeln des Datenausleseteils an das Übertragungsteil, bzw. nach Überführung der Messeinrichtung in den gekoppelten Zustand, vom Datenausleseteil ausgelesen werden können. Ferner kann zur eindeutigen Identifizierung des Übertragungsteils bzw. der Messstelle, an der das Übertragungsteil am Messobjekt angebracht ist, eine Kennung im Datenspeicher abgelegt sein.

Hingegen können zur Messung gewisser Messgrößen, wie zum Beispiel zur Messung von Schwingungen oder Vibrationen des Messobjektes, Sensoren im oder am Datenausleseteil selber bzw. als Teil desselben vorgesehen sein. In solchen Fällen werden im gekoppelten Zustand der Messeinrichtung Schwingungen oder Vibrationen als Messgrößen von dem Messobjekt durch das Übertragungsteil mechanisch an das Datenausleseteil übertragen, wo sie von dem dort angeordneten Sensor erfasst werden können. Im Datenspeicher des Übertragungsteils kann dann anstelle von Daten zuvor gemessener Messgrößen lediglich eine Kennung abgelegt sein, die im gekoppelten Zustand der Messeinrichtung vom Datenausleseteil ausgelesen werden kann, um die Messung bzw. die erfassten Messwerte einer Messstelle am Messobjekt eindeutig zuordnen zu können. Insbesondere kann die Messeinrichtung einen oder mehrere ausschließlich im Datenausleseteil angeordnete Sensoren aufweisen.

Mithin weist bei der Messeinrichtung somit ganz allgemein das Datenausleseteil und/oder das Übertragungsteil wenigstens einen Sensor auf und die Messeinrichtung kann wenigstens einen am Messobjekt anbringbaren Sensor zum Erfassen wenigstens einer Messgröße aufweisen, bei dem es sich um einen Temperatursensor oder einen Schwingungssensor oder einen einaxialen Schwingungssensor oder einen dreiaxialen Schwingungssensor oder einen Beschleunigungssensor oder einen hochfrequenten Beschleunigungssensor oder einen mikromechanischen Beschleunigungssensor oder einen piezoelektrischen Beschleunigungssensor handelt. Dabei werden Temperatursensoren bevorzugt als Teil des Übertragungsteils zur Messung der Temperatur des Messobjektes in der Umgebung des Übertragungsteils vorgesehen. Die gemessenen Temperaturwerte werden bevorzugt im Datenspeicher des Übertragungsteils gespeichert. Sofern die Messeinrichtung zur Messung von Schwingungen oder Vibrationen des Messobjekts vorgesehen ist, weist sie bevorzugt einen vom Datenausleseteil umfassten Schwingungssensor oder Beschleunigungssensor auf. Hierbei kann es sich um einen einaxialen Schwingungssensor, der Schwingungen oder Vibrationen in einer Richtung, üblicherweise in einer Normalenrichtung zur Oberfläche des Messobjektes, misst, oder einen dreiaxialen Schwingungssensor handeln, der Schwingungen oder Vibrationen in drei senkrecht aufeinander stehenden Richtungen misst, wobei üblicherweise eine dieser Richtungen eine Normalenrichtung zur Oberfläche des Messobjektes ist. Bei den Beschleunigungssensoren kann es sich um beliebige Beschleunigungssensoren handeln, wie zum Beispiel um bekannte mikromechanische oder piezoelektrische Beschleunigungssensoren. Da in Maschinenanlagen auftretende Frequenzen zumeist im Bereich von 0 kHz bis 40 kHz liegen, handelt es sich beim Beschleunigungssensor besonders bevorzugt um einen hochfrequenten Beschleunigungssensor zur Erfassung von Schwingungen im hochfrequenten Bereich von 100 Hz bis 20 kHz oder von 100 Hz bis 30 kHz oder von 100 Hz bis 40 kHz oder von 1 kHz bis 30 kHz oder von 1 kHz bis 40 kHz oder von 30 kHz bis 40 kHz. Besonders bevorzugt weist das Datenausleseteil wenigstens einen dreiaxialen Schwingungssensor und zu dessen Unterstützung wenigstens einen hochfrequenten Beschleunigungssensor auf.

Ganz allgemein können die jeweiligen Anlageflächen eben aber auch gebogen oder gekrümmt sein. Bei einer bevorzugten Ausführungsform der erfindungsgemäßen Messeinrichtung sind die jeweiligen Oberflächen der ersten elektrischen Kontakte eben, zueinander parallel und miteinander fluchtend und die jeweiligen Oberflächen der zweiten elektrischen Kontakte sind ebenfalls eben, zueinander parallel und miteinander fluchtend. Vorzugsweise sind bei einer derartigen Messeinrichtung auch die Anlagefläche des Übertragungsteils und die Anlagefläche des Datenausleseteils eben. Ferner sind vorzugsweise nach Anbringen des Übertragungsteils einer derartig ausgeführten Messeinrichtung auf einer ebenen Fläche des Messobjekts im gekoppelten Zustand der Messeinrichtung die Oberflächen der ersten und zweiten Kontakte und somit auch die Anlagefläche des Übertragungsteils und die Anlagefläche des Datenausleseteils parallel zu dieser Fläche ausgerichtet. Ist das Übertragungsteil an einer gekrümmten Fläche des Messobjekts angebracht, so sind im gekoppelten Zustand einer derartigen Messeinrichtung ebene Oberflächen der ersten und zweiten Kontakte bzw. die ebene Anlagefläche des Übertragungsteils und die ebene Anlagefläche des Datenausleseteils bevorzugt parallel zu einer Tangentialebene der gekrümmten Fläche des Messobjekts ausgerichtet. Insbesondere steht die vom Magneten bewirkte Anziehungskraft im gekoppelten Zustand einer Messeinrichtung mit ebenen Anlageflächen vorzugsweise senkrecht zu den Oberflächen ebener erster und zweiter Kontakte, das heißt die vom Magneten bewirkte Anziehungskraft ist im gekoppelten Zustand der Messeinrichtung bezüglich der Oberflächen der ersten und zweiten Kontakte vorzugsweise eine Normalkraft. Hierdurch wird das Ankoppeln des Datenausleseteils an das Übertragungsteil besonders vereinfacht.

Einige Ausführungsformen der erfindungsgemäßen Messeinrichtung weisen mehr als zwei erste und mehr als zwei zweite Kontakte auf. Beispielsweise kann die Messeinrichtung drei erste elektrische Kontakte mit jeweiligen Oberflächen und drei zweite elektrische Kontakte mit jeweiligen Oberflächen aufweisen, wobei die Oberflächen der ersten elektrischen Kontakte mit ihren Flächenschwerpunkten an Ecken eines ersten Dreiecks angeordnet sind und die Oberflächen der zweiten elektrischen Kontakte mit ihren Flächenschwerpunkten an Ecken eines zweiten Dreiecks angeordnet sind. In diesem Fall kann jeweils ein Kontakt der ersten und zweiten Kontakte zur Verbindung mit einem Minuspol einer Stromquelle vorgesehen sein, die sich beispielsweise innerhalb des Übertragungsteils oder des Datenausleseteils oder außerhalb dieser beiden Teile befinden kann, jeweils ein Kontakt der ersten und zweiten Kontakte kann zur Verbindung mit einem Pluspol der Stromquelle vorgesehen sein, und jeweils ein Kontakt der ersten und zweiten Kontakte kann zur Signalübertragung vorgesehen sein. Vorzugsweise sind im gekoppelten Zustand der Messeinrichtung das erste und zweite Dreieck zueinander kongruent.

Besonders bevorzugt ist eine Ausführungsform der Messeinrichtung, bei der das erste und zweite Dreieck rechtwinklige oder gleichseitige Dreiecke sind, wobei nach Aufsetzen des Übertragungsteils auf eine Oberfläche des Messobjekts der vom Datenausleseteil umfasste Sensor im gekoppelten Zustand der Messeinrichtung einen Abstand von dieser Oberfläche hat, der kleiner ist als der Durchmesser oder der Radius eines Umkreises des ersten oder zweiten Dreiecks oder der kleiner ist als eine längste Seite des ersten oder zweiten Dreiecks oder der kleiner ist als eine kleinste Seite des ersten oder zweiten Dreiecks. Eine derartige Ausführung der Messeinrichtung ist insbesondere dann vorteilhaft, wenn die Messeinrichtung zum Messen von Schwingungen oder Vibrationen vorgesehen ist und der hierfür vorgesehene Sensor im Datenausleseteil angeordnet oder ein Teil desselben ist, da der Sensor dann einen kleinen Abstand zum Messobjekt aufweist. Zum Quadrat des Abstands proportionale Trägheitsmomente insbesondere von Massen des Datenausleseteils, die sich auf einer vom Messobjekt abgewandten Seite des Sensors befinden, können sich bei Biege- und Kippbewegungen somit weniger stark auswirken und die Messung dadurch weniger stark verfälschen.

Aus ähnlichen Gründen ist besonders bevorzugt im gekoppelten Zustand nach Aufsetzen des Übertragungsteils auf eine Oberfläche des Messobjekts eine in Normalenrichtung zur Oberfläche des Messobjekts gemessene Gesamterstreckung der Messeinrichtung kleiner oder gleich einer parallel zur Oberfläche des Messobjekts gemessenen Gesamterstreckung der Messeinrichtung.

Der wenigstens eine Magnet, der im gekoppelten Zustand der Messeinrichtung die magnetische Anziehungskraft bewirkt, kann grundsätzlich im bzw. am Datenausleseteil oder im bzw. am Übertragungsteil angeordnet sein, bzw. er kann vom Datenausleseteil oder vom Übertragungsteil umfasst sein bzw. er kann ein Teil des Datenausleseteils oder des Übertragungsteils sein. Bei diesem Magneten handelt es sich vorzugsweise um einen Permanentmagneten, gleichwohl kann aber auch ein Elektromagnet vorgesehen sein. Sofern lediglich das Datenausleseteil oder das Übertragungsteil mit einem Magneten versehen sind, kann der Magnet auf die elektrischen Kontakte des jeweils anderen Teils anziehend wirken und die Kopplung von Datenausleseteil und Übertragungsteil aufgrund der magnetischen Kraft auf die jeweiligen Kontakte bewirken. Bei einer derartigen Ausführungsform der vorliegenden Erfindung ist es besonders vorteilhaft, wenn die ersten und zweiten Kontakte aus einem leicht magnetisierbaren Metall bestehen. Nichtsdestotrotz kann das Übertragungsteil als solches überwiegend aus einem leicht magnetisierbaren Metall gefertigt sein, während es sich bei den ersten und zweiten Kontakten beispielsweise um Goldkontakte handeln kann. Ferner können sowohl das Datenausleseteil als auch das Übertragungsteil wenigstens einen Magneten aufweisen, da mit zwei sich anziehenden Magneten größere Anziehungskräfte im gekoppelten Zustand der Messeinrichtung erreichbar sind, wodurch die Kopplung zwischen Datenausleseteil und Übertragungsteil mechanisch stabiler ist.

Der Magnet kann unterschiedlich ausgeformt sein. Im einfachsten Fall handelt es sich bei dem Magneten um einen Quader. Andererseits kann der Magnet auch ringförmig ausgebildet sein. Dabei können die Kontakte mit ihren Flächenschwerpunkten entlang des ringförmigen Magneten verteilt angeordnet sein. Bei anderen Ausführungsformen sind die ebenen Oberflächen der Kontakte kreisförmig und werden von einem jeweiligen ringförmigen Magneten um- oder eingefasst. Besonders vorteilhaft sind jedoch eine Formgebung und Anordnung der Magnete, bei der sowohl das Datenausleseteil als auch das Übertragungsteil wenigstens einen Magneten aufweisen, deren Magnetfelder, bzw. von diesen bewirkte Magnetkräfte, beim Überführen der Messeinrichtung vom entkoppelten Zustand in den gekoppelten Zustand das Datenausleseteil relativ zum Übertragungsteil zentrieren und/oder ausrichten. Eine derartige Ausführungsform erlaubt ein erheblich erleichtertes und beschleunigtes Ankoppeln des Datenausleseteils an das Übertragungsteil.

Ferner ist bei der Messeinrichtung vorteilhafterweise an einer der jeweiligen Oberfläche wenigstens eines der ersten Kontakte oder zweiten Kontakte abgewandten Seite des betreffenden ersten Kontaktes oder zweiten Kontaktes ein mechanischer Dämpfer vorgesehen. Bei diesem Dämpfer kann es sich beispielsweise um eine Kunststoffschicht handeln. Mittels eines derartigen Dämpfers können unerwünschte Resonanzeffekte, die bei Vibrationen des Messobjektes auftreten und vom Übertragungsteil mechanisch an das Datenausleseteil übertragen werden und die zu Beinträchtigungen von Messungen oder gar zu Beschädigungen der Messeinrichtung führen können, unterbunden oder gar ganz vermieden werden.

Die erfindungsgemäße Messeinrichtung kann Teil eines Systems sein, das ferner wenigstens ein Bedienungsteil aufweist, das mit dem Datenausleseteil verbunden oder verbindbar sein kann. Das Bedienungsteil kann beispielsweise mittels eines Kabels oder drahtlos, insbesondere über eine drahtlose Kommunikationsverbindung, mit dem Datenausleseteil verbunden sein, so dass die vom Datenspeicher ausgelesenen Daten zur weiteren Verarbeitung oder Auswertung über das Kabel oder drahtlos an das Bedienungsteil übertragbar sind. Ferner kann das Bedienungsteil von Sensoren des Datenausleseteils erfasste Messwerte gegebenenfalls nach einer Zwischenspeicherung zur weiteren Verarbeitung oder Auswertung über das Kabel oder drahtlos erhalten. Dabei kann das Bedienungsteil insbesondere eine grafische Anzeige aufweisen, an der die erhaltenen Daten und/oder Messwerte anzeigbar sind. Insbesondere kann das Bedienungsteil zur manuellen oder automatischen bzw. teilautomatischen Steuerung des Datenausleseteils eingerichtet sein.

Die Erfindung wird nachfolgend anhand bevorzugter Ausführungsbeispiele näher erläutert. Dabei zeigen:
- Figur 1a): einen Querschnitt durch eine grundlegende Ausführungsform einer Messeinrichtung im entkoppelten Zustand;
- Figur 1b): die Messeinrichtung der Figur 1a) im gekoppelten Zustand;
- Figur 2: eine weitere Ausführungsform einer Messeinrichtung im gekoppelten Zustand;
- Figur 3: eine Draufsicht auf eine Konfiguration mit drei elektrischen Kontakten;
- Figur 4: eine Draufsicht auf eine weitere Konfiguration mit drei elektrischen Kontakten;
- Figur 5: einen Querschnitt durch einen Teil der Konfiguration der Figur 4;
- Figur 6: einen Querschnitt durch ein System mit einer Messeinrichtung im gekoppelten Zustand.

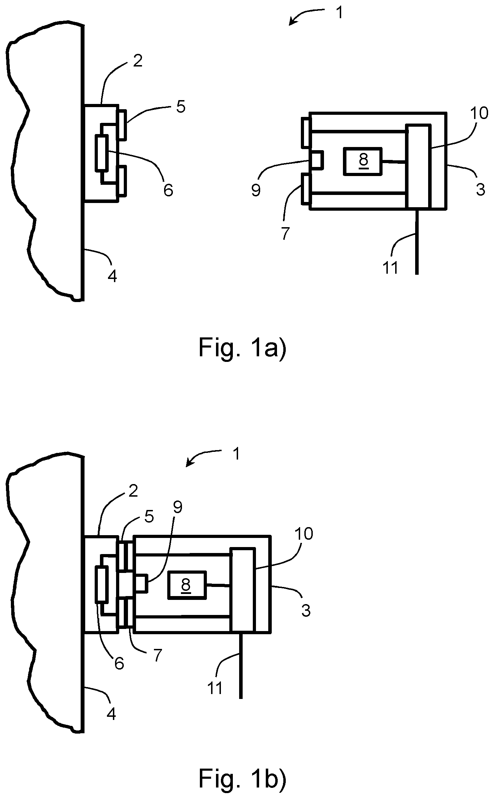

Ein nicht maßstabsgerechter, da schematischer Querschnitt durch eine grundlegende Ausführungsform einer Messeinrichtung (1), die zur Vibrationsmessung von Maschinen vorgesehen ist, ist in der Figur 1a) in einem entkoppelten Zustand und in der Figur 1b) in einem gekoppelten Zustand zu sehen. Die Messeinrichtung (1) umfasst ein Übertragungsteil (2) und ein Datenausleseteil (3).

Das aus einem Automatenstahl gefertigte Übertragungsteil (2) ist in den Figuren 1a) und 1b) auf der Oberfläche einer Maschine (4) angeordnet zu sehen, die der Messeinrichtung (1) als Messobjekt dient. An einer der Maschine (4) abgewandten Oberfläche des Übertragungsteils (2) sind zwei vorspringende elektrische Kontakte (5) aus Metall vorgesehen, von denen jeder an einer der Maschine (4) abgewandten Seite eine ebene Oberfläche aufweist. Dabei sind die ebenen Oberflächen der Kontakte (5) nicht nur zueinander parallel, sondern zudem auch noch miteinander fluchtend in einer Ebene angeordnet, so dass die Gesamtheit der ebenen Oberflächen der Kontakte (5) jeweilige disjunkte bzw. getrennte Teilbereiche einer unzusammenhängenden Anlagefläche bilden. Im Inneren des Übertragungsteils (2) ist ein mit den Kontakten (5) verbundener Datenspeicher (6) vorgesehen. Im Datenspeicher (6) ist eine Kennung abgespeichert.

Das Datenausleseteil (3) weist an einer Stirnseite zwei elektrische Kontakte (7) mit jeweils ebenen, zueinander parallelen und miteinander fluchtenden Oberflächen auf, die den elektrischen Kontakten (5) des Übertragungsteils (2) ähnlich ausgebildet sind. Insbesondere bildet die Gesamtheit der ebenen Oberflächen der Kontakte (7) des Datenausleseteils (3) jeweilige getrennte oder disjunkte Teilbereiche einer unzusammenhängenden Anlagefläche, die mit der durch die Gesamtheit der ebenen Oberflächen der Kontakte (5) des Übertragungsteils (2) gebildeten Anlagefläche im Wesentlichen deckungsgleich ist. Ferner ist im Inneren des Datenausleseteils (3) ein dreiaxialer Beschleunigungssensor (8) vorgesehen. Zwischen den Kontakten (7) weist das Datenausleseteil (3) einen Magnetpol oder Magneten (9) auf, dessen magnetische Kräfte auf das aus Automatenstahl gefertigte Übertragungsteil (2) anziehend wirken. Sowohl die Kontakte (7) als auch der Beschleunigungssensor (8) sind mit einem Datenbus (10) verbunden, der in ein externes Kabel (11) mündet.

Wie bereits erwähnt kann die Messeinrichtung (1) sowohl den in der Figur 1a) dargestellten entkoppelten Zustand einnehmen, in dem das Übertragungsteil (2) und das Datenausleseteil (3) voneinander getrennt sind, sie kann aber auch durch einfaches Ansetzen des Datenausleseteils (2) an das Übertragungsteil (3) in den in der Figur 1b) dargestellten gekoppelten Zustand überführt werden. Die Kopplung oder Verbindung zwischen Übertragungsteil (2) und Datenausleseteil (3) wird aufgrund der auf das Übertragungsteil (2) wirkenden magnetischen Anziehungskraft des Magneten (9) bewirkt und aufrechterhalten. Im gekoppelten Zustand liegen das Übertragungsteil (2) und das Datenausleseteil (3) mit ihren jeweiligen Kontakten bzw. den durch ihre Oberflächen gebildeten Anlageflächen aneinander an, wobei jeweils einer der Kontakte (5) des Übertragungsteils (2) mit seiner ebenen Oberfläche an der ebenen Oberfläche eines jeweiligen der Kontakte (7) des Datenausleseteils (3) anliegt.

Im gekoppelten Zustand der Figur 1b) ist die Messeinrichtung (1) zur Messung von Vibrationen der Maschine (4) betriebsbereit. Hierbei lässt sich infolge der über die aneinander anliegenden elektrischen Kontakte (5) und (7) hergestellten elektrischen Verbindung die im Datenspeicher (6) des Übertragungsteils (2) abgelegte Kennung vom Datenausleseteil (3) auslesen und an den Datenbus (10) und von diesem weiter über das Kabel (11) an ein in den Figuren 1a) und 1b) nicht dargestelltes Gerät, beispielsweise ein Bedienungsteil oder einen Computer, übertragen und damit das Übertragungsteil (2) bzw. der Messort an der Maschine (4) identifizieren. Die eigentliche Messung der Vibrationen der Maschine (4) erfolgt im gekoppelten Zustand der Messeinrichtung (1) mittels des Beschleunigungssensors (8), dessen Messwerte ebenfalls über den Datenbus (10) und das Kabel (11) an das nicht gezeigte externe Gerät übertragen werden, wo sie weiter verarbeitet, analysiert oder grafisch dargestellt werden können. In Kombination mit der Kennung aus dem Datenspeicher (6) lassen sich diese Messwerte dem Übertragungsteil (2) bzw. einem Messort am Messobjekt (4) eindeutig zuordnen. Nach erfolgter Messung kann das Datenausleseteil (3) auf einfache Weise manuell vom Übertragungsteil (2) getrennt werden, wodurch die Messeinrichtung (1) vom gekoppelten Zustand der Figur 1b) wieder in den entkoppelten Zustand der Figur 1a) überführt wird.

Obwohl bei der Messeinrichtung (1) der Magnet (9) am Datenausleseteil (3) vorgesehen ist, kann er alternativ auch am Übertragungsteil (2) angeordnet sein, sofern das Datenausleseteil (3) wenigstens teilweise aus einem Metall besteht, welches von den Magnetkräften des Magneten (9) angezogen wird. Desweiteren können sowohl das Datenausleseteil (3) als auch das Übertragungsteil (2) mit jeweiligen Magneten versehen sein, die mit ihren Polen derart angeordnet sind, dass sie sich im gekoppelten Zustand der Messeinrichtung (1) gegenseitig anziehen.

Ferner müssen die Oberflächen der elektrischen Kontakte (5) des Übertragungsteils (2) und der elektrischen Kontakte (7) des Datenausleseteils (3) nicht notwendigerweise eben ausgebildet sein. Sie können vielmehr auch eine gekrümmte oder gebogene Form aufweisen, so dass auch die jeweiligen Anlageflächen des Übertragungsteils (2) und des Datenausleseteils (3) wenigstens teilweise von entsprechend gekrümmter oder gebogener Form sind.

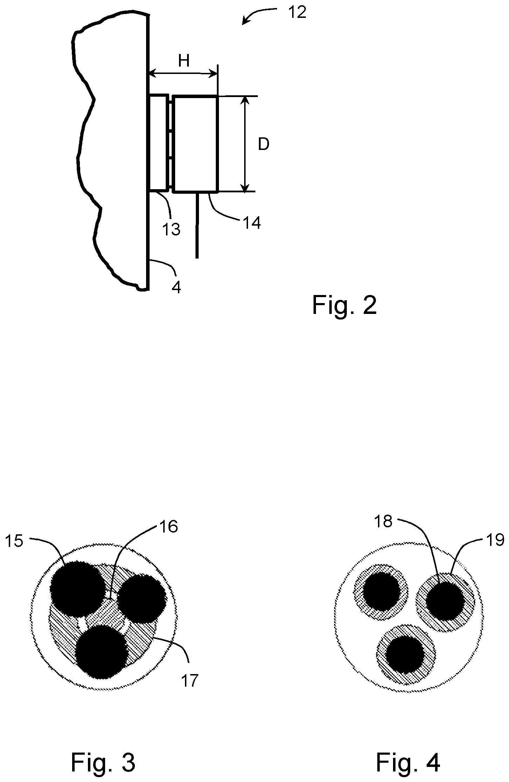

In der Figur 2 ist zur Messung von Vibrationen der Maschine (4) anstatt der Messeinrichtung (1) eine alternative Messeinrichtung (12) mit einem an der Oberfläche der Maschine (4) angebrachten Übertragungsteil (13) und einem Datenausleseteil (14) im gekoppelten Zustand dargestellt, die bis auf die Abmessungen der Messeinrichtung (1) der Figuren 1a) und 1b) entspricht. Die Abmessungen der Messeinrichtung (12) sind nun jedoch derart gewählt, dass im dargestellten gekoppelten Zustand eine in Normalenrichtung zu den Oberflächen der Kontakte des Übertragungsteils (13) und des Datenausleseteils (14), bzw. in Normalenrichtung zur Oberfläche der Maschine (4), gemessene Erstreckung H der Messeinrichtung (12) kleiner einer parallel zu den Oberflächen der Kontakte oder der Oberfläche der Maschine (4) gemessenen Erstreckung D der Messeinrichtung (12) ist. Diese Dimensionierung der Messeinrichtung (12) stellt sicher, dass sich der in dem Datenausleseteil (14) befindliche Beschleunigungssensor möglichst nahe an der Oberfläche der Maschine (4) befindet, so dass Trägheitseffekte von Massen des Datenausleseteils (14), die sich auf einer der Maschine (4) abgewandten Seite des Beschleunigungssensors befinden, möglichst keine Auswirkungen auf die Messung des Beschleunigungssensors haben. Darüber hinaus ist bei einer derart flachen Ausführung der Messeinrichtung (12) deren mechanische Stabilität im gekoppelten Zustand erhöht.

Anstatt jeweils nur zwei elektrische Kontakte vorzusehen, können auch jeweils drei elektrische Kontakte für das Übertragungsteil und das Datenausleseteil vorgesehen sein. In den Figuren 3 und 4 sind verschiedene Konfigurationen mit jeweils drei elektrischen Kontakten (15) und (18) dargestellt, die sowohl für ein Übertragungsteil als auch für ein Datenausleseteil möglich sind. Hierbei kann beispielsweise jeweils einer der drei Kontakte (15) und (18) für den Anschluss an einen Pluspol einer Stromquelle vorgesehen sein und jeweils einer der Kontakte (15) und (18) kann für den Anschluss an den Minuspol der Stromquelle vorgesehen sein, während der verbleibende dritte Kontakt (15) und (18) zur Datensignalübertragung vorgesehen sein kann.

Bei der in der Figur 3 dargestellten Konfiguration sind die drei vollkreisförmigen elektrischen Kontakte (15) gleichen Durchmessers an den Ecken eines imaginären gleichseitigen Dreiecks angeordnet. An einer der ebenen Oberfläche dieser Kontakte (15) entgegengesetzten Seite, in der Figur 3 also unterhalb der Kontakte (15), sind ein erster vollkreisförmiger Magnetpol oder Magnet (16) mit einem vollkreisförmigen Magnetpol und ein zweiter kreisringförmiger Magnetpol oder Magnet (17) mit einem kreisringförmigen Magnetpol angeordnet, wobei der erste Magnet (16) vom zweiten Magneten (17) umfasst wird. Die Mittelpunkte des ersten Magneten (16) und des zweiten Magneten (17) fallen mit dem Schnittpunkt der Winkelhalbierenden des imaginären Dreiecks zusammen, wobei die Mittelpunkte der Kontakte (15) entlang der Mittellinie des zweiten Magneten (17) angeordnet sind.

Auch bei der in der Figur 4 dargestellten Draufsicht auf eine weitere Konfiguration dreier vollkreisförmiger elektrischer Kontakte gleichen Durchmessers sind die elektrischen Kontakte (18) an den Ecken eines imaginären gleichseitigen Dreiecks angeordnet. Anders als bei der Konfiguration der Figur 3 ist bei der Konfiguration der Figur 4 nun jedoch für jeden einzelnen der Kontakte (18) ein jeweiliger vollkreisförmiger Magnetpol oder Magnet (19) mit vollkreisförmigem Magnetpol an einer den ebenen Oberflächen der Kontakte (18) entgegengesetzten Seite, in der Figur 4 also unterhalb der Kontakte (18), vorgesehen, wobei die Magnete (19) einen größeren Durchmesser aufweisen als die Kontakte (18) und jeder Magnet (19) mit einem jeweiligen der Kontakte (18) konzentrisch ist.

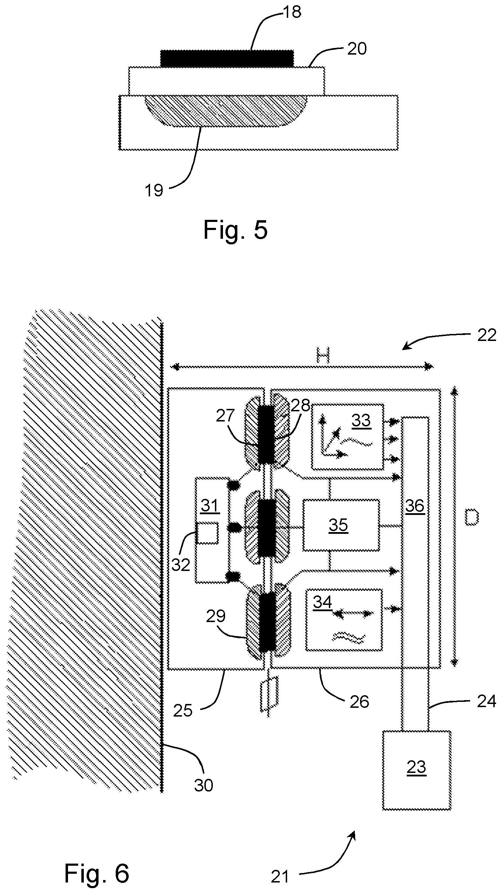

Zwischen den elektrischen Kontakten (15) und (18) und den Magneten (16), (17) und (19) kann ein mechanischer Dämpfer vorgesehen sein. Dies ist in der Figur 5 verdeutlicht, die für eine Ausführung mit mechanischem Dämpfer beispielhaft einen Querschnitt durch einen Teil der in der Figur 4 gezeigten Konfiguration in der Umgebung eines der Kontakte (18) zeigt. In der Figur 5 ist deutlich eine als mechanischer Dämpfer vorgesehene Leiterplatte (20) zu sehen, die zwischen Kontakt (18) und Magnet (19) angeordnet ist. Bei dieser Leiterplatte (20) handelt es sich um eine weiche Glasfaser-Epoxyd Leiterplatte (20), die lediglich 0,3 mm dick sein kann, welche die Dämpfung hoher Resonanzfrequenzen bewirkt und damit den mechanischen Kontakt zwischen Übertragungsteil und Datenausleseteil verbessert. Jedoch ist auch die Übertragung hoher Frequenzen möglich, solange die Masse des Datenausleseteils nicht zu hoch ist. Vorzugsweise sind mechanische Dämpfer wie die Leiterplatte (20) auch bei anderen Konfigurationen elektrischer Kontakte vorgesehen, wie zum Beispiel bei der Konfiguration der Figur 3, und zwar unabhängig von der Anzahl der Kontakte. So kann insbesondere auch bei den in den Figuren 1a), 1b) und 2 dargestellten Messeinrichtungen (1) und (12) an einer den ebenen Oberflächen der Kontakte (5) der Übertragungsteile (2) und (13) abgewandten Seite eine derartige Leiterplatte an den Übertragungsteilen (2) und (13) vorgesehen sein, und entsprechend kann an einer den ebenen Oberflächen der Kontakte (7) der Datenausleseteile (3) und (14) abgewandten Seite eine Leiterplatte an den Datenausleseteilen (3) und (14) vorgesehen sein.

In der Figur 6 ist ein System (21) mit einer erfindungsgemäßen Messeinrichtung (22) im gekoppelten Zustand und einem Bedienungsteil oder tragbaren Auswertegerät (23) zu sehen, die über ein Kabel (24) miteinander verbunden sind. Wie die zuvor beschriebenen Messeinrichtungen (1) und (12) weist auch die Messeinrichtung (22) des Systems (21) ein Übertragungsteil (25) und ein Datenausleseteil (26) auf, wobei die Messeinrichtung (22) zusätzlich zu dem in der Figur 6 gezeigten gekoppelten Zustand auch einen entkoppelten Zustand einnehmen kann, in welchem Datenausleseteil (26) und Übertragungsteil (25) voneinander getrennt sind.

Im Unterschied zu den Messeinrichtungen (1) und (12) umfasst das Übertragungsteil (25) jedoch nunmehr drei aus Gold bestehende vorspringende Kontakte (27) mit jeweiligen ebenen, zueinander parallelen und miteinander fluchtenden Oberflächen, deren Gesamtheit eine ebene unzusammenhängende Anlagefläche bildet. Entsprechend umfasst auch das Datenausleseteil (26) an seiner Stirnseite drei aus Gold bestehende vorspringende Kontakte (28) mit jeweiligen ebenen, zueinander parallelen und miteinander fluchtenden Oberflächen, deren Gesamtheit eine ebene unzusammenhängende Anlagefläche bildet und die im in der Figur 6 dargestellten gekoppelten Zustand der Messeinrichtung (22) an den ebenen Oberflächen der Kontakte (27) anliegen und dadurch eine elektrisch leitende Verbindung zwischen Übertragungsteil (25) und Datenausleseteil (26) herstellen. Wie bei der Konfiguration des Beispiels der Figur 4 ist bei dem vorliegenden Übertragungsteil (25) und dem vorliegenden Datenausleseteil (26) an einer der jeweiligen Oberfläche jedes der Kontakte (27) und (28) abgewandten Seite jeweils ein scheibenförmiger Magnetpol oder Magnet (29) mit einem Durchmesser angeordnet, der größer ist als der Durchmesser des zugehörigen Kontaktes (27) oder (28). Die Magnete (29) sind derart am Übertragungsteil (25) und Datenausleseteil (26) angeordnet und mit ihren Polungen ausgerichtet, dass sich im gezeigten gekoppelten Zustand der Messeinrichtung (22) einander gegenüberliegende Magnete (29) jeweils gegenseitig anziehen und dadurch für eine mechanisch feste Kopplung des Übertragungsteils (25) und des Datenausleseteils (26) sorgen, wobei die Anziehungskräfte der Magnete (29) im Wesentlichen normal zu den ebenen Oberflächen der Kontakte (27) und (28) wirken.

Bei dem Übertragungsteil (25) handelt es sich um ein mit einer galvanischen Schutzschicht überzogenes Automatenstahl-Drehteil von ungefähr 20 mm Durchmesser, das auf die Oberfläche einer Maschine (30) geklebt ist. Es umfasst sowohl einen mit den Kontakten (27) verbundenen, programmierbaren und löschbaren Datenspeicher (31) als auch einen Temperatursensor (32) zum Messen von Temperaturen der Maschine (30), wobei vom Temperatursensor (32) erfasste Messwerte im Datenspeicher (31) abgelegt werden. Zudem ist eine Kennung im Datenspeicher (31) abgelegt.

Das Datenausleseteil (26) weist hingegen neben den Kontakten (28) und den Magneten (29) ferner einen dreiaxialen Beschleunigungssensor (33), einen hochfrequenten Beschleunigungssensor (34), einen Parameterspeicher (35) und einen Datenbus (36) auf, der in das externe Kabel (24) mündet. Die Beschleunigungssensoren (33) und (34) sowie der Parameterspeicher (35) sind über jeweilige serielle Schnittstellen mit dem Datenbus (36) verbunden. Somit verbindet das Kabel (24) die Messeinrichtung (22), bzw. das Datenausleseteil (26) der Messeinrichtung (22), mit dem tragbaren Auswertegerät (23). Dabei sind die Dimensionen der Messeinrichtung (22) derart gewählt, dass ihre Gesamtbreite D parallel zur Oberfläche der Maschine (30) größer als die Gesamthöhe H senkrecht zur Oberfläche der Maschine (30) ist. Hierdurch ist das Datenausleseteil (26) sehr flach gebaut, wodurch es auch in Querrichtung messen kann ohne zu kippeln und Beschleunigungsamplituden von rund 50 g übertragen werden können. Zudem ist die Masse des Datenausleseteils (26) kleiner als 10 g, so dass es Bewegungen der Maschine (30) bis zu Beschleunigungen von 100 g folgen kann.

Im in der Figur 6 dargestellten gekoppelten Zustand der Messeinrichtung (22) ist das Datenausleseteil (26) durch die infolge der aneinander anliegenden Kontakte (27) und (28) hergestellte elektrische Verbindung mit dem Übertragungsteil (25) bzw. mit dem Datenspeicher (31) in die Lage versetzt, im Datenspeicher (31) gespeicherte Messwerte des Temperatursensors (32) sowie die Kennung aus dem Datenspeicher (31) auszulesen und über den Datenbus (36) und das Kabel (24) an das tragbare Auswertegerät (23) zu übertragen. Ferner kann das System (21) im gezeigten gekoppelten Zustand der Messeinrichtung (22) mittels der Beschleunigungssensoren (33) und (34) Vibrationen oder Schwingungen der Maschine (30) messen, wobei der an sich bekannte dreiaxiale Beschleunigungssensor (33) zur Messung von Schwingungen in drei zueinander orthogonalen Richtungen vorgesehen ist, während der hochfrequente Beschleunigungssensor (34) die Messung in einer Normalenrichtung zur Oberfläche der Maschine (30) unterstützt, da dreiaxiale Beschleunigungssensoren (33) zumeist einen eingeschränkten Frequenz-Dynamikbereich haben. Für die Messung können unterschiedliche vordefinierte und im Parameterspeicher (35) abgelegte Parameter unterstützend herangezogen werden. Von den Beschleunigungssensoren (33) und (34) erfasste Messwerte werden über die jeweiligen seriellen Schnittstellen an den Datenbus (36) übergeben und von diesem über das Kabel (24) an das tragbare Auswertegerät (23) übermittelt. Das Auswertegerät (23) speichert und analysiert die erhaltenen Daten und ermöglicht deren grafische Darstellung an einem in der Figur 6 nicht gezeigten Bildschirm. Zudem kann der Messbetrieb der Messeinrichtung (22) mittels des Auswertegeräts (23) gesteuert werden, indem Steuerbefehle vom Auswertegerät (23) über das Kabel (24) und den Datenbus (36) an die Beschleunigungssensoren (33) und (34) und den Parameterspeicher (35) sowie über die elektrische Verbindung der aneinander anliegenden Kontakte (27) und (28) an den Datenspeicher (31) und den Temperatursensor (32) übertragen werden.

### Bezugszeichenliste

- 1.: Messeinrichtung
- 2.: Übertragungsteil
- 3.: Datenausleseteil
- 4.: Maschine
- 5.: elektrischer Kontakt des Übertragungsteils
- 6.: Datenspeicher
- 7.: elektrischer Kontakt des Datenausleseteils
- 8.: dreiaxialer Beschleunigungssensor
- 9.: Magnet oder Magnetpol
- 10.: Datenbus
- 11.: Kabel
- 12.: Messeinrichtung
- 13.: Übertragungsteil
- 14.: Datenausleseteil
- 15.: Kontakt
- 16.: Magnet oder Magnetpol
- 17.: Magnet oder Magnetpol
- 18.: Kontakt
- 19.: Magnet oder Magnetpol
- 20.: Leiterplatte
- 21.: System
- 22.: Messeinrichtung
- 23.: Auswertegerät
- 24.: Kabel
- 25.: Übertragungsteil
- 26.: Datenausleseteil
- 27.: Kontakte
- 28.: Kontakte
- 29.: Magnet oder Magnetpol
- 30.: Maschine
- 31.: Datenspeicher
- 32.: Temperatursensor
- 33.: dreiaxialer Beschleunigungssensor
- 34.: hochfrequenter Beschleunigungssensor
- 35.: Parameterspeicher
- 36.: Datenbus

## Patentansprüche

1. Messeinrichtung (1, 12, 22) zur Messung einer Messgröße eines Messobjektes (4, 30), die wenigstens ein an Messobjekten (4, 30) anbringbares Übertragungsteil (2, 13, 25) mit wenigstens einem Datenspeicher (6, 31) und wenigstens zwei ersten elektrischen Kontakten (5, 27) mit jeweiligen Oberflächen, die jeweilige Teilbereiche einer Anlagefläche des Übertragungsteils (2, 13, 25) bilden,
wenigstens ein Datenausleseteil (3, 14, 26) mit wenigstens zwei zweiten elektrischen Kontakten (7, 28) mit jeweiligen Oberflächen, die jeweilige Teilbereiche einer Anlagefläche des Datenausleseteils (3, 14, 26) bilden, wobei das Übertragungsteil und/oder das Datenausleseteil wenigstens einen Magneten (9, 29) aufweist, wobei das Datenausleseteil und/oder das Übertragungsteil (2, 13, 25) wenigstens einen Sensor zur Messung der Messgröße des Messobjektes (4, 30) aufweist und die Messeinrichtung (1, 12, 22) eingerichtet ist
einen entkoppelten Zustand einzunehmen, in welchem die ersten elektrischen Kontakte (5, 27) von den zweiten elektrischen Kontakten (7, 28) beabstandet sind und
einen gekoppelten Zustand einzunehmen, in welchem das Datenausleseteil (3, 14, 26) und das Übertragungsteil (2, 13, 25) aufgrund einer vom Magneten (9, 29) bewirkten Anziehungskraft aneinander gekoppelt sind, wobei die Anlagefläche des Übertragungsteils (2, 13, 25) und die Anlagefläche des Datenausleseteils (3, 14, 26) aneinander anliegen und jeweils einer der ersten elektrischen Kontakte (5, 27) mit seiner Oberfläche an der Oberfläche eines jeweiligen der zweiten elektrischen Kontakte (7, 28) anliegt, wodurch elektrisch leitende Verbindungen zwischen jeweiligen aneinander anliegenden ersten Kontakten (5, 27) und zweiten Kontakten (7, 28) bestehen, die es dem Datenausleseteil (3, 14, 26) ermöglichen, im Datenspeicher (6, 31) gespeicherte Daten auszulesen.

2. Messeinrichtung (1, 12, 22) nach Anspruch 1, die wenigstens einen am Messobjekt (4, 30) anbringbaren Sensor zum Erfassen wenigstens einer Messgröße aufweist, bei dem es sich um einen Temperatursensor (32) oder einen Schwingungssensor oder einen einaxialen Schwingungssensor oder einen dreiaxialen Schwingungssensor (8, 33) oder einen Beschleunigungssensor oder einen hochfrequenten Beschleunigungssensor (34) oder einen mikromechanischen Beschleunigungssensor oder einen piezoelektrischen Beschleunigungssensor handelt.

3. Messeinrichtung (1, 12, 22) nach Anspruch 1 oder 2, bei der die jeweiligen Oberflächen der ersten elektrischen Kontakte (5, 27) eben, zueinander parallel und miteinander fluchtend sind und bei der die jeweiligen Oberflächen der zweiten elektrischen Kontakte (7, 28) eben, zueinander parallel und miteinander fluchtend sind.

4. Messeinrichtung (22) nach einem der vorhergehenden Ansprüche, die drei erste elektrische Kontakte (27) mit jeweiligen Oberflächen und drei zweite elektrische Kontakte (28) mit jeweiligen Oberflächen aufweist, wobei die Oberflächen der ersten elektrischen Kontakte (27) mit ihren Flächenschwerpunkten an Ecken eines ersten Dreiecks angeordnet sind und die Oberflächen der zweiten elektrischen Kontakte (28) mit ihren Flächenschwerpunkten an Ecken eines zweiten Dreiecks angeordnet sind.

5. Messeinrichtung (22) nach den Anspruch 4, bei der das erste und zweite Dreieck rechtwinklige oder gleichseitige Dreiecke sind, wobei nach Aufsetzen des Übertragungsteils (25) auf eine Oberfläche des Messobjekts (30) der vom Datenausleseteil (26) umfasste Sensor im gekoppelten Zustand der Messeinrichtung (22) einen Abstand von dieser Oberfläche hat, der kleiner ist als der Durchmesser oder der Radius eines Umkreises des ersten oder zweiten Dreiecks oder der kleiner ist als eine längste Seite des ersten oder zweiten Dreiecks oder der kleiner ist als eine kleinste Seite des ersten oder zweiten Dreiecks.

6. Messeinrichtung (12, 22) nach einem der vorhergehenden Ansprüche, bei der im gekoppelten Zustand nach Aufsetzen des Übertragungsteils (13, 25) auf eine Oberfläche des Messobjekts (4, 30) eine in Normalenrichtung zur Oberfläche des Messobjekts (4, 30) gemessene Gesamterstreckung der Messeinrichtung (12, 22) kleiner oder gleich einer parallel zur Oberfläche des Messobjekts (4, 30) gemessenen Gesamterstreckung der Messeinrichtung (12, 22) ist.

7. Messeinrichtung (22) nach einem der vorhergehenden Ansprüche, bei welcher sowohl das Datenausleseteil (26) als auch das Übertragungsteil (25) wenigstens einen Magneten (29) aufweisen, deren Magnetfelder beim Überführen der Messeinrichtung (22) vom entkoppelten Zustand in den gekoppelten Zustand das Datenausleseteil (26) relativ zum Übertragungsteil (25) zentrieren und/oder ausrichten.

8. Messeinrichtung (1, 12, 22) nach einem der vorhergehenden Ansprüche, bei der an einer der jeweiligen Oberfläche wenigstens eines der ersten Kontakte (5, 27) oder zweiten Kontakte (7, 28) abgewandten Seite des betreffenden ersten Kontaktes (5, 27) oder zweiten Kontaktes (7, 28) ein mechanischer Dämpfer (20) vorgesehen ist.

9. System (21) mit wenigstens einer Messeinrichtung (1, 12, 22) nach einem der vorhergehenden Ansprüche und wenigstens einem Bedienungsteil (23), das mit dem Datenausleseteil (3, 14, 26) über ein Kabel (11, 24) oder drahtlos verbunden oder verbindbar ist.

## Claims

1. Measuring device (1, 12, 22) for measuring a measured variable of an object to be measured (4, 30), which measuring device comprises
at least one transmitting part (2, 13, 25) which can be attached to objects to be measured (4, 30) and has at least one data memory (6, 31) and at least two first electrical contacts (5, 27) with respective surfaces which form respective sub-areas of a bearing face of the transmitting part (2, 13, 25),
at least one data reading part (3, 14, 26) with at least two second electrical contacts (7, 28) with respective surfaces which form respective sub-areas of a bearing face of the data reading part (3, 14, 26), wherein the transmitting part and/or the data reading part have/has at least one magnet (9, 29), wherein the data reading part and/or the transmitting part (2, 13, 25) have/has at least one sensor for measuring the measured variable of the object to be measured (4, 30) and
the measuring device (1, 12, 22) is configured
to assume an uncoupled state in which the first electrical contacts (5, 27) are spaced apart from the second electrical contacts (7, 28), and
to assume a coupled state in which the data reading part (3, 14, 26) and the transmitting part (2, 13, 25) are coupled to one another owing to an attractive force which is brought about by the magnet (9, 29), wherein the bearing face of the transmitting part (2, 13, 25) and the bearing face of the data reading part (3, 14, 26) bear one against the other, and in each case one of the first electrical contacts (5, 27) bears with its surface against the surface of a respective one of the second electrical contacts (7, 28), as a result of which the electrically conductive connections exist between respective first contacts (5, 27) which bear one against the other and second contacts (7, 28) which permit the data reading part (3, 14, 26) to read data stored in the data memory (6, 31).

2. Measuring device (1, 12, 22) according to Claim 1, which has at least one sensor which can be attached to the object to be measured (4, 30) and has the purpose of acquiring at least one measured variable, which sensor is a temperature sensor (32) or an oscillation sensor or a monoaxial oscillation sensor or a triaxial oscillation sensor (8, 33) or an acceleration sensor or a high-frequency acceleration sensor (34) or a micromechanical acceleration sensor or a piezo-electric acceleration sensor.

3. Measuring device (1, 12, 22) according to Claim 1 or 2, in which the respective surfaces of the first electrical contacts (5, 27) are flat and parallel and aligned with respect to one another and in which the respective surfaces of the second electrical contacts (7, 28) are flat and parallel and aligned with respect to one another.

4. Measuring device (22) according to one of the preceding claims, which has three first electrical contacts (27) with respective surfaces and three second electrical contacts (28) with respective surfaces, wherein the surfaces of the first electrical contacts (27) are arranged with their area centroids at corners of a first triangle, and the surfaces of the second electrical contacts (28) are arranged with their area centroids at corners of a second triangle.

5. Measuring device (22) according to Claim 4, in which the first and second triangles are right-angled or equilateral triangles, wherein after the transmitting part (25) has been fitted onto a surface of the object to be measured (30), the sensor which is included in the data reading part (26) is, in the coupled state of the measuring device (22), at a distance from this surface which is shorter than a diameter or the radius of a circumscribed circle of the first or second triangle or which is shorter than a longest side of the first or second triangle or which is shorter than a shortest side of the first or second triangle.

6. Measuring device (12, 22) according to one of the preceding claims, in which in the coupled state after the transmitting part (13, 25) has been fitted onto a surface of the object to be measured (4, 30), a total extent of the measuring device (12, 22), measured in the normal direction with respect to the surface of the object to be measured (4, 30), is shorter than or equal to a total extent of the measuring device (12, 22), measured parallel with respect to the surface of the object to be measured (4, 30).

7. Measuring device (22) according to one of the preceding claims, in which both the data reading part (26) and the transmitting part (25) have at least one magnet (29), the magnetic fields of which center and/or align the data reading part (26) relative to the transmitting part (25) when the measuring device (22) is changed from the uncoupled state into the coupled state.

8. Measuring device (1, 12, 22) according to one of the preceding claims, in which a mechanical damper (20) is provided on a side of the affected first contact (5, 27) or second contact (7, 28) facing away from the respective surface of at least one of the first contacts (5, 27) or second contacts (7, 28).

9. System (21) having at least one measuring device (1, 12, 22) according to one of the preceding claims and at least one operator control part (23) which is or can be connected to the data reading part (3, 14, 26) via a cable (11, 24) or in a wireless fashion.

## Revendications

1. Système de mesure (1, 12, 22), destiné à mesurer une grandeur de mesure d'un objet à mesurer (4, 30), qui comporte au moins un élément de transmission (2, 13, 25), susceptible d'être monté sur des objets à mesurer (4, 30), pourvu d'au moins une mémoire de données (6, 31) et d'au moins deux premiers contacts électriques (5, 27) dotés de surfaces respectives qui forment des zones partielles respectives d'une surface d'appui de l'élément de transmission (2, 13, 25), au moins un élément lecteur de données (3, 14, 26) pourvu d'au moins deux deuxièmes contacts électriques (7, 28), dotés de surfaces respectives, qui forme des zones partielles respectives d'une surface d'appui de l'élément lecteur de données (3, 14, 26), l'élément de transmission et/ou l'élément lecteur de données comportant au moins un aimant (9, 29), l'élément lecteur de données et/ou l'élément de transmission (2, 13, 25) comportant au moins un capteur, destiné à mesure la grandeur de mesure de l'objet à mesurer (4, 30) et le système de mesure (1, 12, 22) étant aménagé pour
adopter un état désaccouplé dans lequel les premiers contacts électriques (5, 27) sont écartés des deuxièmes contacts électriques (7, 28) et
pour adopter un état accouplé dans lequel l'élément lecteur de données (3, 14, 26) et l'élément de transmission (2, 13, 25) sont accouplés l'un à l'autre, du fait d'une force d'attraction exercée par l'aimant (9, 29), la surface d'appui de l'élément de transmission (2, 13, 25) et la surface d'appui de l'élément lecteur de données (3, 14, 26) étant adjacentes et chaque fois l'un des premiers contacts électriques (5, 27) étant adjacent par sa surface à la surface de l'un respectif des deuxièmes contacts électriques (7, 28), ce qui donne naissance entre des premiers contacts (5, 27) et deuxièmes contacts (7, 28) respectivement adjacents à des connexions conductrices d'électricité, qui permettent à l'élément lecteur de données (3, 14, 26) de lire des données mémorisées dans la mémoire de données (6, 31).

2. Système de mesure (1, 12, 22) selon la revendication 1, qui comporte au moins un capteur susceptible d'être monté sur l'objet à mesurer (4, 30) pour la détection d'au moins une grandeur de mesure, celui-ci étant un capteur de température (32) ou un capteur de vibrations ou un capteur de vibrations uni-axial ou un capteur de vibrations triaxial (8, 33) ou un capteur d'accélérations ou un capteur d'accélérations haute fréquence (34) ou un capteur d'accélérations micromécanique ou un capteur d'accélérations piézoélectrique.

3. Système de mesure (1, 12, 22) selon la revendication 1 ou 2, sur lequel les surfaces respectives des premiers contacts électriques (5, 27) sont planes, mutuellement parallèles et alignées les unes sur les autres et sur lequel les surfaces respectives des deuxièmes contacts électriques (7, 28) sont planes, mutuellement parallèles et alignées les unes sur les autres.

4. Système de mesure (22) selon l'une quelconque des revendications précédentes, qui comporte trois premiers contacts électriques (27) pourvus de surfaces respectives et trois deuxièmes contacts électriques (28) pourvus de surfaces respectives, les surfaces des premiers contacts électriques (27) étant placées par leurs barycentres sur des angles d'un premier triangle et les surfaces des deuxièmes contacts électriques (28) étant placées par leurs barycentres sur des angles d'un deuxième triangle.

5. Système de mesure (22) selon la revendication 4, sur lequel le premier et deuxième triangles sont des triangles rectangles ou équilatéraux, après le placement de l'élément de transmission (25) sur une surface de l'objet à mesurer (30), dans l'état accouplé du système de mesure (22), le capteur englobé par l'élément lecteur de données (26) présentant par rapport à ladite surface un écart qui est inférieur au diamètre ou au rayon d'une périphérie du premier ou deuxième triangle ou qui est inférieur à un côté longitudinal du premier ou deuxième triangle ou qui est inférieur à un plus petit côté du premier ou deuxième triangle.

6. Système de mesure (12, 22) selon l'une quelconque des revendications précédentes, sur lequel, dans l'état accouplé, après la pose de l'élément de transmission (13, 25) sur une surface de l'objet à mesurer (4, 30), une extension totale du système de mesure (12, 22) dans la direction normale par rapport à la surface de l'objet à mesurer (4, 30) est inférieure ou égale à une extension totale du système de mesure (12, 22), mesurée à la parallèle de la surface de l'objet à mesurer (4, 30).

7. Système de mesure (22) selon l'une quelconque des revendications précédentes, sur lequel aussi bien l'élément lecteur de données (26) qu'également l'élément de transmission (25) comportent au moins un aimant (29) dont les champs magnétiques centrent et/ou alignent l'élément lecteur de données (26) par rapport à l'élément de transmission (25), lors du passage du système de mesure (22) de l'état désaccouplé dans l'état accouplé.

8. Système de mesure (1, 12, 22) selon l'une quelconque des revendications précédentes, sur lequel, sur l'une des surfaces respectives d'au moins l'un des côtés opposés aux premiers contacts (5, 27) ou aux deuxièmes contacts (7, 28) du premier contact (5, 27) ou deuxième contact (7, 28) concerné est prévu un amortisseur mécanique (20).

9. System (21), pourvu d'au moins un système de mesure (1, 12, 22) selon l'une quelconque des revendications précédentes et d'au moins un élément de commande (23), qui par l'intermédiaire de l'élément lecteur de données (3, 14, 26) sont connectés ou susceptibles d'être connectés via un câble (11, 24) ou sans fil.
